(19) Europäisches Patentamt
European Patent Office
Office européen des brevets

(11) EP 3 698 417 B1

(12) **EUROPÄISCHE PATENTSCHRIFT**

(45) Veröffentlichungstag und Bekanntmachung des Hinweises auf die Patenterteilung:
**13.05.2026 Patentblatt 2026/20**

(21) Anmeldenummer: **18796376.4**

(22) Anmeldetag: **18.10.2018**

(51) Internationale Patentklassifikation (IPC):
***H10K 50/11*** *(2023.01)* *F21S 43/145* *(2018.01)*
*F21S 41/155* *(2018.01)*

(52) Gemeinsame Patentklassifikation (CPC):
**H10K 50/11;** F21S 41/155; F21S 43/145;
H10K 2101/20

(86) Internationale Anmeldenummer:
**PCT/EP2018/078578**

(87) Internationale Veröffentlichungsnummer:
**WO 2019/077051 (25.04.2019 Gazette 2019/17)**

(54) **BELEUCHTUNGSEINRICHTUNG FÜR KRAFTFAHRZEUGE UND ERHÖHTE BETRIEBSTEMPERATUREN**

LIGHTING DEVICE FOR MOTOR VEHICLES AND INCREASED OPERATING TEMPERATURES

DISPOSITIF D’ÉCLAIRAGE POUR VÉHICULES À MOTEUR ET TEMPÉRATURES DE FONCTIONNEMENT AUGMENTÉES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.10.2017 DE 102017218708**

(43) Veröffentlichungstag der Anmeldung:
**26.08.2020 Patentblatt 2020/35**

(73) Patentinhaber: **Samsung Display Co., Ltd.**
**Gyeonggi-do 17113 (KR)**

(72) Erfinder:
- **VOLZ, Daniel**
  **76137 Karlsruhe (DE)**
- **FLÜGGE, Harald**
  **76135 Karlsruhe (DE)**

(74) Vertreter: **Jacobi, Markus Alexander**
**Patentanwälte**
**Isenbruck Bösl Hörschler PartG mbB**
**Eastsite One**
**Seckenheimer Landstrasse 4**
**68163 Mannheim (DE)**

(56) Entgegenhaltungen:
**EP-A1- 3 389 107** **WO-A1-2017/099160**
**DE-B3- 102016 108 332** **JP-A- 2017 188 399**

- **MICHAEL Y. WONG ET AL: "Purely Organic Thermally Activated Delayed Fluorescence Materials for Organic Light-Emitting Diodes", ADVANCED MATERIALS, vol. 29, no. 22, 3 March 2017 (2017-03-03), DE, pages 1605444 - 1, XP055457416, ISSN: 0935-9648, DOI: 10.1002/adma.201605444**
- **WANG ZHIMING ET AL: "Phenanthro[9,10-d] imidazole as a new building block for blue light emitting materials", JOURNAL OF MATERIALS CHEMISTRY, vol. 21, no. 14, 28 February 2011 (2011-02-28), GB, pages 5451, XP093124483, ISSN: 0959-9428, Retrieved from the Internet <URL:https://pubs.rsc.org/en/content/articlepdf/2011/jm/c1jm10321k> DOI: 10.1039/c1jm10321k**
- **MOUNGGON KIM ET AL: "Stable Blue Thermally Activated Delayed Fluorescent Organic Light-Emitting Diodes with Three Times Longer Lifetime than Phosphorescent Organic Light-Emitting Diodes", ADVANCED MATERIALS, vol. 27, no. 15, 10 March 2015 (2015-03-10), DE, pages 2515 - 2520, XP055496933, ISSN: 0935-9648, DOI: 10.1002/adma.201500267**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Processed by Luminess, 75001 PARIS (FR)

## Beschreibung

Die vorliegende Erfindung betrifft eine Verwendung einer Beleuchtungseinrichtung wie in Anspruch 1 definiert, ein Kraftfahrzeug wie in Anspruch 12 definiert, und ein Verfahren zum Erzeugen von Licht wie in Anspruch 13 definiert.

Beleuchtungseinrichtungen basierend auf organischen lichtemittierenden Dioden (OLEDs) zeichnen sich dadurch aus, dass sie auf Grund ihres dünnen, leichten und flexiblen Aufbaus neue Gestaltungsformen ermöglichen. So können OLEDbasierte Beleuchtungseinrichtungen im Kraftfahrzeugbereich auf die Karosserie oder auf Grund der möglichen Transparenz der OLED auf den Scheiben des Fahrzeuges aufgebraucht, insbesondere aufgeklebt werden. Ebenso kann die OLED-Beleuchtungseinrichtung in die Scheibe integriert werden oder von innen auf die Scheibe aufgebracht werden. Ebenfalls ist eine Aufbringung auf eine bereits vorhandene Beleuchtungseinrichtung möglich. DE-A 10217633 beschreibt verschiedene Anwendungsmöglichkeiten OLED-basierter Außenbeleuchtungseinrichtungen. Ebenfalls werden in JP 2017 188399 A, DE-A 102009009087, DE-A 102013217848, DE-A 102014111119 und WO 2014/179824 OLEDs-basierte Beleuchtungen in Kraftfahrzeugen gelehrt.

Die hierein gelehrten OLEDs weisen jedoch zum Teil suboptimale Eigenschaften auf. So ist es bekannt, dass derartige herkömmliche OLEDs bei erhöhten Temperaturen zunehmend schlechtere optische Eigenschaften und verringerte Lebensdauern aufweisen.

Für Anwendungen in der Außenbeleuchtung von Kraftfahrzeugen müssen OLEDs auch bei hohen Umgebungstemperaturen die gesetzlich geforderte Leuchtdichte über einen langen Betriebszeitraum aufweisen. Bereits außerhalb des Betriebs kann durch äußere Einflüsse wie der Solarstrahlung die Beleuchtungseinrichtung Temperaturen deutlich über der Umgebungstemperatur ausgesetzt sein. Während des Betriebes wird die Bauteiltemperatur durch die Eigenerwärmung der OLED weiter erhöht. Es können typischerweise etwa Temperaturen im Bereich von 30°C bis über 100°C, mitunter bis zu 160°C, erreicht werden. Die im Stand der Technik im Kraftfahrzeugbereich verwendeten OLEDs erfüllen diese Anforderungen, insbesondere an die Temperaturstabilität regelmäßig nicht. Daher wird die Verwendung von OLEDs in Kraftfahrzeugen bislang erheblich erschwert.

Es bestand daher ein Bedarf an OLEDs für den Kraftfahrzeugbereich, die bei einer Verwendung bei erhöhten Temperaturen eine hohe Effizienz und eine ausreichende Lebensdauer aufweisen.

Überraschend wurde gefunden, dass die Verwendung von OLEDs, die das Prinzip der thermisch aktivierten verzögerten Fluoreszenz (TADF) nutzen, in Beleuchtungseinrichtungen im Kraftfahrzeugbereich besonders vorteilhaft ist. Insbesondere konnte die Temperaturstabilität und Lebensdauer der OLEDs unter Bedingungen, wie sie im Kraftfahrzeugbereich üblich sind, erheblich verbessert werden. Die externe Quanteneffizienz (EQE) einer solchen auf TADF beruhenden OLED kann mit steigender Temperatur sogar steigen.

Ein erster Aspekt der Offenbarung betrifft daher eine Beleuchtungseinrichtung für ein Kraftfahrzeug, enthaltend mindestens eine organische lichtemittierende Diode (OLED) mit einer Emissionsschicht B, wobei die Emissionsschicht B mindestens einen Emitter E enthält, der Licht mittels thermisch aktivierter verzögerter Fluoreszenz (TADF) emittiert.

Anders ausgedrückt betrifft die Offenbarung eine Beleuchtungseinrichtung, die am oder im Kraftfahrzeug angeordnet ist (oder angeordnet wird), enthaltend mindestens eine organische lichtemittierende Diode (OLED) mit einer Emissionsschicht B,
wobei die Emissionsschicht B mindestens einen Emitter E enthält, der Licht mittels thermisch aktivierter verzögerter Fluoreszenz (TADF) emittiert.

Üblicherweise weist eine OLED folgenden Aufbau auf:

- ein Substrat,
- eine Anode,
- mindestens eine Emissionsschicht B (lichtemittierende Schicht), und
- eine Kathode,

wobei die Anode oder die Kathode auf das Substrat aufgebracht sind, und die mindestens eine Emissionsschicht zwischen Anode und Kathode angeordnet ist.

Typischerweise befinden sich eine oder mehrere Lochinjektions- und/ oder Lochtransport- und/ oder Elektronenblockier-Schichten zwischen Anode und lichtemittierender Schicht B und eine oder mehrere Elektroneninjektions- und/ oder Elektronentransport- und/ oder Lochblockier-Schichten zwischen Kathode und lichtemittierender Schicht B. Die einzelnen Schichten werden sequentiell abgeschieden.

Die Emissionsschicht B stellt einen zentralen Bestandteil der OLED dar. Wird eine Spannung an da OLED Bauteil angelegt, werden Löcher und Elektronen von Anode und Kathode injiziert. Durch Rekombination der Löcher und Elektronen in der Emissionsschicht werden Exzitonen erzeugt. Die Relaxation aus angeregten Zuständen (z.B. aus Singulett-Zuständen wie S1 und/ oder Triplett-Zuständen wie T1) in den Grundzustand S0 sollte über Lichtemission erfolgen.

Die Emissionsschicht B enthält einen thermisch-aktivierte verzögerte Fluoreszenz-(TADF)-Emitter E. TADF-Emitter weisen eine ersten angeregten Triplett-Zustand T1 auf, der ausreichend nahe energetisch unter dem ersten angeregten Singulett-Zustand S1 liegt, dass bis zu 100% der bei der Rekombination von Löchern und Elektronen entstehenden Exzitonen für die Lichtemission genutzt werden können. Dadurch wird eine thermische Rückbesetzung des S1-Zustandes aus dem T1-Zustand möglich.

Gemäß einer bevorzugten Ausführungsform weist der Emitter E eine Energiedifferenz ΔE zwischen dem untersten angeregten Singulett-Zustand S1 und dem darunterliegenden Triplett-Zustand T1 (E(S1-T1)-Wert) von nicht mehr als 0,3 eV auf.

Gemäß einer noch stärker bevorzugten Ausführungsform weist der Emitter E einen E(S1-T1)-Wert von nicht mehr als 0,2 eV, insbesondere von nicht mehr als 0,1 eV, auf.

Auf Grund der thermischen Rückbesetzung des S1-Zustandes hängen bei TADF-Emittern typischerweise die Intensität der Lichtemission (daher auch die Quantentausbeute) und die Emissionslebensdauer von der Temperatur ab. Im Gegensatz zu Fluoreszenz- und Phosphoreszenz-Emittern, bei denen die Quanteneffizienz, insbesondere die Photolumineszenz-Quantenausbeute (phospholuminscence quantum yield, PLQY), und die Exzitonen-Lebensdauer tau keine Funktion der Temperatur sind, sinkt bei TADF-Emittern die Exzitonen-Lebensdauer zwischen Raumtemperatur (daher etwa 20 °C) und 70 °C weiter ab, während die Quanteneffizienz steigt (und/oder zumindest nicht/weniger als erwartet abnimmt).

Gemäß einer bevorzugten Ausführungsform steigt daher die externe Quanteneffizienz (EQE) der OLED mit steigender Temperatur.

Gemäß einer bevorzugten Ausführungsform nimmt daher die externe Quanteneffizienz (EQE) der OLED nicht mit steigender Temperatur ab oder nimmt weniger als erwartet ab.

Die in der Anmeldung verwendeten Begriffe "TADF-Material" und "TADF-Emitter" sind synonym zu verstehen und untereinander austauschbar.

Der Emitter E kann grundsätzlich eine beliebige chemische Struktur aufweisen. Er kann beispielhaft rein organisch sein, kann einen Metallkomplex darstellen oder sonstige anorganische Bestandteile enthalten.

Gemäß einer bevorzugten Ausführungsform ist der Emitter E ein rein organischer TADF-Emitter.

Daher weist der Emitter E bevorzugt keine Metallionen auf. Reine organische TADF-Emitter E sind dem Fachmann bekannt. Beispielhafte Emitter für die Farben blau, grün und rot beschreiben Wong und Zysman-Colman ("Purely Organic Thermally Activated Delayed Fluorescence Materials for Organic Light-Emitting Diodes.", Adv Mater. 2017 Jun;29(22)) und EP-A 3113239.

Der Emitter E kann eine beliebige Molekulargröße aufweisen. Er kann groß- oder kleinmolekular sein. Gemäß einer bevorzugten Ausführungsform weist der Emitter E eine Molekülmasse von mehr als 1000 g/mol auf. Gemäß einer anderen bevorzugten Ausführungsform weist der Emitter E eine Molekülmasse von nicht mehr als 1000 g/mol auf. Beispielhaft kann der Emitter E eine Molekülmasse im Bereich von 200 bis 10000 g/mol, 300 bis 5000 g/mol, 400 bis 2000 g/mol, 250 bis 1000 g/mol, 500 bis 1000 g/mol, über 1500 g/mol oder über 2000 g/mol aufweisen.

Gemäß einer bevorzugten Ausführungsform weist der Emitter E ein Emissionsmaximum im Bereich von 420 nm bis 800 nm auf. Gemäß einer bevorzugten Ausführungsform weist der Emitter E ein Emissionsmaximum im Bereich von 420 nm bis 600 nm auf.

Gemäß einer stark bevorzugten Ausführungsform weist der rein organische Emitter E eine Energiedifferenz ΔE zwischen dem untersten angeregten Singulett-Zustand S1 und dem darunterliegenden Triplett-Zustand T1 von nicht mehr als 0,3 eV, ein Emissionsmaximum im Bereich von 420 nm bis 800 nm (beispielhaft von 420 nm bis 600 nm) auf.

Der offenbarte Emitter E weist bevorzugt Emissionen im sichtbaren Bereich des Spektrums auf. Stärker bevorzugt weist der Emitter E ein Emissionsmaximum im blauen, himmelblauen, grünen, gelben oder roten Spektralbereich auf.

Auch die offenbarte OLED weist bevorzugt Emissionen im sichtbaren Bereich des Spektrums auf. Stärker bevorzugt weist die OLED ein Emissionsmaximum im blauen, himmelblauen oder grünen Spektralbereich auf. Gemäß einer bevorzugten Ausführungsform weist die OLED daher ein Emissionsmaximum im Bereich von 420 nm bis 800 nm beispielhaft von 420 nm bis 600 nm) auf. Gemäß einer stärker bevorzugten Ausführungsform weist die OLED daher ein Emissionsmaximum im Bereich von 420 nm bis 800 nm (beispielhaft von 420 nm bis 600 nm) auf und die die externe Quanteneffizienz (EQE) der OLED steigt (und/oder nimmt zumindest nicht/weniger als erwartet ab) mit steigender Temperatur.

Die Photolumineszenzquantenausbeute (PLQY) des offenbarten Emitters E beträgt bevorzugt 20 % und mehr. Die Verwendung des Emitters E in einer optoelektronischen Vorrichtung, beispielsweise einer OLED kann zu höheren Effizienzen der Vorrichtung führen.

Entsprechende OLEDs weisen typischerweise eine höhere Stabilität auf als OLEDs mit bekannten Emitter-Materialien und vergleichbarer Farbe.

Unter dem blauen Spektralbereich wird hier der sichtbare Bereich von kleiner als 470 nm, bevorzugt von 420 bis 470 nm verstanden. Unter dem himmelblauen Spektralbereich wird hier der Bereich von 470 nm bis 499 nm verstanden. Unter dem grünen Spektralbereich wird hier der Bereich von 500 nm bis 569 nm verstanden. Unter dem gelben

Spektralbereich wird hier der Bereich von 570 nm bis 639 nm verstanden und unter dem roten Spektralbereich der Bereich von 640 nm bis 800 nm. Dabei liegt das Emissionsmaximum im jeweiligen Bereich. Beispielhaft kann die OLED daher ein Emissionsmaximum im Bereich von 420 nm bis 470 nm, im Bereich von 470 nm bis 499 nm, im Bereich von 500 nm bis 569 nm, im Bereich von 570 nm bis 639 nm oder im Bereich von 640 nm bis 800 nm aufweisen.

Eine bevorzugte Ausführungsform der Offenbarung betrifft einen Emitter E, der einen $\Delta E(S_1-T_1)$-Wert zwischen dem untersten angeregten Singulett ($S_1$)- und dem darunter liegenden Triplett ($T_1$)-Zustand von nicht höher als 5000 $cm^{-1}$, insbesondere nicht höher als 3000 $cm^{-1}$, oder nicht höher als 1500 $cm^{-1}$ oder 1000 $cm^{-1}$ aufweist und/oder eine Emissionslebensdauer von höchstens 150 $\mu$s, insbesondere von höchstens 100 $\mu$s, von höchsten 50 $\mu$s, oder von höchstens 10 $\mu$s aufweisen und/oder eine Hauptemissionsbande mit einer Halbwertsbreite kleiner als 0,55 eV, insbesondere kleiner als 0,50 eV, kleiner als 0,48 eV, oder kleiner als 0,45 eV aufweist.

Die Beleuchtungseinrichtung für ein Kraftfahrzeug kann jegliche Beleuchtungseinrichtung sein, die in oder an einem Kraftfahrzeug einsetzbar ist bzw. eingesetzt wird sein. Diese kann an der Innen- oder der Außenseite des Kraftfahrzeugs angebracht werden bzw. angebracht sein oder in andere Elemente des Kraftfahrzeugs eingebaut sein.

Gemäß einer bevorzugten Ausführungsform ist die Beleuchtungseinrichtung eine Signalleuchte an der Außenseite des Kraftfahrzeugs. Gemäß einer weiter bevorzugten Ausführungsform ist die Beleuchtungseinrichtung eine Signalleuchte an der Außenseite des Kraftfahrzeugs, die ausgewählt ist aus der Gruppe bestehend aus einem alternierend leuchtenden Fahrtrichtungsanzeiger, einem Schlusslicht, einem Bremslicht, einem Signallicht zum Anzeigen des autonomen oder manuellen Fahrbetriebs, einer optional hochgesetzten Bremsleuchte und einem Außendisplay.

Der Emitter E kann eine beliebige Glasübergangstemperatur (einen beliebigen Glasübergangspunkt) aufweisen. Gemäß einer bevorzugten Ausführungsform weist der Emitter E eine Glasübergangstemperatur von über 130 °C auf.

Stärker bevorzugt weist der Emitter E eine Glasübergangstemperatur von über über 140 °C, insbesondere von über 150 °C, auf.

Auch die Emissionsschicht B kann eine beliebige Glasübergangstemperatur aufweisen. Bevorzugt weist die Emissionsschicht B eine Glasübergangstemperatur von über 120 °C, stärker bevorzugt von über 130 °C, noch stärker bevorzugt von über 140 °C, insbesondere von über 150 °C, auf.

Gemäß einer bevorzugten Ausführungsform enthält die Emissionsschicht B ausschließlich Materialien, die eine Glasübergangstemperatur von über 120 °C aufweisen.

Stärker bevorzugt enthält die Emissionsschicht B ausschließlich Materialien, die eine Glasübergangstemperatur von über 130 °C, noch stärker bevorzugt von über 140 °C, insbesondere von über 150 °C, aufweisen.

Bevorzugt behält auch die gesamte OLED ihre mechanische Festigkeit bei höheren Temperaturen bei. Gemäß einer bevorzugten Ausführungsform stellt daher die offenbarten Beleuchtungseinrichtung eine thermostabile Beleuchtungseinrichtung dar und die OLED enthält ausschließlich Materialien, die eine Glasübergangstemperatur von über 120 °C aufweisen.

Bevorzugt enthält die OLED ausschließlich Materialien, die eine Glasübergangstemperatur von über 130 °C, noch stärker bevorzugt von über 140 °C, insbesondere von über 150 °C, aufweisen. Gemäß einer bevorzugten Ausführungsform wird die Beleuchtungseinrichtung am oder im Kraftfahrzeug so angeordnet, dass sie beim Langzeitbetrieb des Kraftfahrzeugs bei einer Außentemperatur von 20°C einer um mindestens 10°C gegenüber der Außentemperatur erhöhten Betriebstemperatur ausgesetzt wird. Gemäß einer stärker bevorzugten Ausführungsform wird die Beleuchtungseinrichtung am oder im Kraftfahrzeug so angeordnet, dass sie beim Langzeitbetrieb des Kraftfahrzeugs bei einer Außentemperatur von 20°C einer um mindestens 25°C gegenüber der Außentemperatur erhöhten Betriebstemperatur ausgesetzt wird.

Wie hierin verwendet, bedeutet "Langzeitbetrieb" eine Betriebszeit, bei der die Temperatur nicht mehr signifikant steigt, daher bei gleichbleibender Außentemperatur eine um nicht mehr als 5°C niedrigere Temperatur aufweist als maximal bei Dauerbetrieb bei dieser konstanten Außentemperatur erreicht wird. Bevorzugt stellt ein "Langzeitbetrieb" einen Betrieb des Kraftfahrzeugs für mindestens 15 min, stärker bevorzugt einen Betrieb des Kraftfahrzeugs für mindestens 30 min, insbesondere einen Betrieb des Kraftfahrzeugs für mindestens 1 h dar.

Gemäß einer bevorzugten Ausführungsform der offenbarten Beleuchtungseinrichtung ist der Emitter E als Emissionsmaterial in der Emissionsschicht B eingesetzt, wobei er entweder als Reinschicht oder in Kombination mit einem oder mehreren Hostmaterialien eingesetzt wird.

Der Massenanteil des Emitter E an der Emissionsschicht B beträgt gemäß einer bevorzugten Ausführungsform zwischen 1 % und 80 %. Die Emissionsschicht B kann gemäß einer alternativen Ausführungsform auch ausschließlich aus dem Emitter E bestehen, wobei die Anode und die Kathode auf das Substrat aufgebracht sein können, und die Emissionsschicht B zwischen Anode und Kathode angeordnet sein kann.

Gemäß einer bevorzugten Ausführungsform ist die Emissionsschicht B auf ein Substrat aufgebracht, wobei bevorzugt eine Anode und eine Kathode auf das Substrat aufgebracht sind und die Emissionsschicht B zwischen Anode und Kathode aufgebracht ist.

Gemäß einer bevorzugten Ausführungsform umfasst die offenbarte Zusammensetzung der Emissionsschicht B

einen Emitter E und ein oder mehrere Hostmaterialien. Stärker bevorzugt betrifft die Offenbarung eine Zusammensetzung aufweisend oder bestehend aus:

(a) mindestens einem offenbarten organischen Molekül, bevorzugt als Emitter und/oder Host, insbesondere Emitter E, und
(b) optional mindestens ein, d.h. ein oder mehrere Emitter- und/oder Hostmaterialien, die von Emitter E verschiedenen ist bzw. sind und
(c) optional eine oder mehreren Farbstoffen und/ oder einem oder mehreren organischen Lösungsmitteln.

Gemäß einer bevorzugten Ausführungsform umfasst die Emissionsschicht B daher:

(a) den Emitter E;
(b) einen oder mehrere Hostmaterialien H, die von dem Emitter E verschieden sind;
(c) einen oder mehrere TADF-Emitter K, die von dem Emitter E verschieden sind, und
(d) einen oder mehrere weitere Komponenten ausgewählt aus der Liste bestehend aus einem oder mehreren Emittern F, die keine TADF-Emitter darstellen, einem oder mehreren Farbstoffen C, einem oder mehreren Lösungsmitteln L und Kombinationen aus zwei oder mehr daraus.

Gemäß einer stärker bevorzugten Ausführungsform besteht die Emissionsschicht B aus:

(a) dem Emitter E;
(b) einem oder mehreren Hostmaterialien H, die von dem Emitter E verschieden sind;
(c) einem oder mehreren TADF-Emittern K, die von dem Emitter E verschieden sind, und
(d) einer oder mehrerer weiterer Komponenten ausgewählt aus der Liste bestehend aus einem oder mehreren Emittern F, die keine TADF-Emitter darstellen, einem oder mehreren Farbstoffen C, einem oder mehreren Lösungsmitteln L und Kombinationen aus zwei oder mehr daraus.

In anderen Worten ist die offenbarte Beleuchtungseinrichtung bevorzugt dadurch gekennzeichnet, dass die Emissionsschicht B aus einer Zusammensetzung aufweisend (oder bestehend aus):

(a) einen Emitter E
(b) ein Hostmaterial H und
(c) optional ein weiteres Hostmaterial D oder einen Fluoreszenz-Emitter F oder einen TADF-Emitter K,
wobei E, H, D, F und K jeweils verschieden sind.

Das oder die Hostmaterialen weisen bevorzugt Triplett (T1)- und Singulett (S1)-Energieniveaus auf, die energetisch höher liegen als die Triplett (T1)- und Singulett (S1)- Energieniveaus des Emitters E. In einer bevorzugten Ausführungsform weist die Zusammensetzung neben dem Emitter E ein elektronendominantes und/oder ein lochdominantes Hostmaterial auf. Das höchste besetzte Orbital (HOMO) und das niedrigste unbesetzte Orbital (LUMO) des lochdominanten Hostmaterials liegen energetisch bevorzugt höher als das des elektronendominanten Hostmaterials.

Das HOMO des lochdominanten Hostmaterials liegt energetisch bevorzugt unter dem HOMO des Emitters E, während das LUMO des elektronendominanten Hostmaterials energetisch bevorzugt über dem LUMO des Emitters E. Um Exciplex-Formation zwischen Emitter und Hostmaterial oder Hostmaterialien zu vermeiden, werden die Materialien bevorzugt so gewählt sein, dass die Energieabstände zwischen den jeweiligen Orbitalen gering sind. Der Abstand zwischen dem LUMO des elektronendominanten Hostmaterials und dem LUMO des Emitters E beträgt bevorzugt weniger als 0,5 eV, stärker bevorzugt weniger als 0,3 eV, insbesondere weniger als 0,2 eV. Der Abstand zwischen dem HOMO des lochdominanten Hostmaterials und dem HOMO des Emitters E beträgt bevorzugt weniger als 0,5 eV, bevorzugt weniger als 0,3 eV, insbesondere weniger als 0,2 eV.

Gemäß einer bevorzugten Ausführungsform weist eine OLED gemäß der vorliegenden Offenbarung folgenden Aufbau auf:

- ein Substrat,
- eine Anode,
- mindestens eine Emissionsschicht B, enthaltend Emitter E und optional weitere Komponenten ausgewählt aus einem oder mehreren Hostmaterialien H, einem oder mehreren TADF-Emittern K und einer oder mehrerer weiterer Komponenten wie jeweils hierin beschrieben, und
- eine Kathode,

wobei die Anode oder die Kathode auf das Substrat aufgebracht sind, und die mindestens eine Emissionsschicht B, die zwischen Anode und Kathode angeordnet ist.

Gemäß einer bevorzugten Ausführungsform handelt es sich bei der optoelektronischen Vorrichtung um eine OLED, die bevorzugt folgenden Schichtaufbau aufweist:

1. Substrat (Trägermaterial)
2. Anode
3. Lochinjektionsschicht (hole injection layer, HIL)
4. Lochtransportschicht (hole transport layer, HTL)
5. Elektronenblockierschicht (electron blocking layer, EBL)
6. offenbarte Emissionsschicht B (mit Emitter E) (emitting layer, EML)
7. Lochblockierschicht (hole blocking layer, HBL)
8. Elektronenleitschicht (electron transport layer, ETL)
9. Elektroneninjektionsschicht (electron injection layer, EIL)
10. Kathode.

Dabei können einzelne Schichten lediglich in optionaler Weise vorhanden sein. Weiterhin können mehrere dieser Schichten zusammenfallen. Und es können einzelne Schichten mehrfach im Bauteil vorhanden sein.

Gemäß einer bevorzugten Ausführungsform ist mindestens eine Elektrode des organischen Bauelements transluzent ausgebildet. Hier wird mit "transluzent" eine Schicht bezeichnet, die durchlässig für sichtbares Licht (daher insbesondere einen Wellenlängenbereich von 420 bis 750 nm, bevorzugt 400 bis 800 nm) ist. Dabei kann die transluzente Schicht klar durchscheinend, also transparent, oder zumindest teilweise Licht absorbierend und/oder teilweise Licht streuend sein, so dass die transluzente Schicht beispielsweise auch diffus oder milchig durchscheinend sein kann. Insbesondere ist eine hier als transluzent bezeichnete Schicht möglichst transparent ausgebildet, so dass insbesondere die Absorption von Licht so gering wie möglich ist.

Gemäß einer alternativen Ausführungsform weist das organische Bauelement, insbesondere eine OLED, einen invertierten Aufbau auf. Der invertierte Aufbau zeichnet sich dadurch aus, dass sich die Kathode auf dem Substrat befindet und die anderen Schichten entsprechend invertiert aufgebracht werden:

1. Substrat (Trägermaterial)
2. Kathode
3. Elektroneninjektionsschicht (electron injection layer, EIL)
4. Elektronenleitschicht (electron transport layer, ETL)
5. Lochblockierschicht (hole blocking layer, HBL)
6. offenbarte Emissionsschicht B (enthaltend Emitter E) (emitting layer, EML)
7. Elektronenblockierschicht (electron blocking layer, EBL)
8. Lochtransportschicht (hole transport layer, HTL)
9. Lochinjektionsschicht (hole injection layer, HIL)
10. Anode

Auch hierbei können einzelne Schichten lediglich in optionaler Weise vorhanden sein. Weiterhin können mehrere dieser Schichten zusammenfallen. Und es können einzelne Schichten mehrfach im Bauteil vorhanden sein.

Gemäß einer Ausführungsform der offenbarten organischen optoelektronischen Vorrichtung sind eine löcher- und elektroneninjizierende Schicht zwischen Anode und Kathode, und eine löcher- und elektronentransportierende Schicht zwischen löcher- und elektroneninjizierender Schicht, und die Emissionsschicht B zwischen löcher- und elektronentransportierender Schicht aufgebracht.

Die organische optoelektronische Vorrichtung weist gemäß einer weiteren Ausführungsform der Offenbarung auf: ein Substrat, eine Anode, eine Kathode und mindestens je eine löcher- und elektroneninjizierende Schicht, und mindestens je eine löcher- und elektronentransportierende Schicht, und mindestens eine Emissionsschicht B, die Emitter E und ein oder mehrere Hostmaterialen aufweist, deren Triplett ($T_1$)- und Singulett ($S_1$)-Energieniveaus energetisch höher liegen als die Triplett ($T_1$)- und Singulett ($S_1$)-Energieniveaus des Emitters E, wobei die Anode und die Kathode auf das Substrat aufgebracht ist, und die löcher- und elektroneninjizierende Schicht zwischen Anode und Kathode aufgebracht ist, und die löcher- und elektronentransportierende Schicht zwischen löcher- und elektroneninjizierender Schicht aufgebracht ist, und die Emissionsschicht B zwischen löcher- und elektronentransportierender Schicht aufgebracht ist.

In einer bevorzugten Ausführungsform wird bei der invertierten OLED die Anodenschicht des typischen Aufbaus, z.B. eine ITO-Schicht (Indium-Zinn-Oxid), als Kathode geschaltet.

Gemäß einer weiteren bevorzugten Ausführungsform weist die offenbarte Beleuchtungseinrichtung einen gestapelten Aufbau auf, wobei die einzelnen OLEDs übereinander und nicht wie üblich nebeneinander angeordnet

werden. Durch einen gestapelten Aufbau kann die Erzeugung von Mischlicht ermöglicht werden. Beispielsweise kann dieser Aufbau bei der Erzeugung von weißem Licht eingesetzt werden, für dessen Erzeugung das gesamte sichtbare Spektrum typischerweise durch die Kombination des emittierten Lichts von blauen, grünen und roten Emittern abgebildet wird.

Weiterhin können bei praktisch gleicher Effizienz und identischer Leuchtdichte signifikant längere Lebensdauern im Vergleich zu üblichen OLEDs erzielt werden. Für den gestapelten Aufbau wird optional eine sogenannte Ladungserzeugungsschicht (charge generation layer, CGL) zwischen zwei OLEDs eingesetzt. Diese kann aus einer n-dotierten und einem p-dotierten Schicht bestehen, wobei die n-dotierte Schicht typischerweise näher an der Anode aufgebracht wird.

In einer Ausführungsform - einer sogenannten Tandem-OLED - treten zwei oder mehr Emissionsschichten zwischen Anode und Kathode auf. In einer Ausführungsform sind drei Emissionsschichten übereinander angeordnet, wobei eine Emissionsschicht rotes Licht emittiert, eine Emissionsschicht grünes Licht emittiert und eine Emissionsschicht blaues Licht emittiert und optional weitere Ladungserzeugungs-, Blockier- oder Transportschichten zwischen den einzelnen Emissionsschichten aufgebracht sind. In einer weiteren Ausführungsform werden die jeweiligen Emissionsschichten direkt angrenzend aufgebracht. In einer weiteren Ausführungsform befindet sich jeweils eine Ladungserzeugungsschicht zwischen den Emissionsschichten. Weiterhin können in einer OLED direkt angrenzende und durch Ladungserzeugungsschichten getrennte Emissionsschichten kombiniert werden.

Über den Elektroden und den organischen Schichten kann weiterhin noch eine Verkapselung angeordnet sein. Die Verkapselung kann beispielsweise in Form eines Glasdeckels oder in Form einer Dünnschichtverkapselung ausgeführt sein.

Als Trägermaterial der optoelektronischen Vorrichtung kann beispielsweise Glas, Quarz, Kunststoff, Metall, ein Siliziumwafer oder jedes andere geeignete feste oder flexible, optional durchsichtige Material dienen. Das Trägermaterial kann beispielsweise ein oder mehrere Materialien in Form einer Schicht, einer Folie, einer Platte oder einem Laminat aufweisen.

Als Anode der optoelektronischen Vorrichtung können beispielsweise transparente leitende Metalloxide wie beispielsweise ITO (Indium-Zinn-Oxid), Zinkoxid, Zinnoxid, Cadmiumoxid, Titanoxid, Indiumoxid oder Aluminiumzinkoxid (AZO), $Zn_2SnO_4$, $CdSnO_3$, $ZnSnO_3$, $MgIn_2O_4$, $GaInO_3$, $Zn_2In_2O_5$ oder $In_4Sn_3O_{12}$ oder Mischungen unterschiedlicher transparenter leitender Oxide dienen.

Als Materialien einer HIL können beispielsweise PEDOT:PSS (Poly-3,4-ethylendioxythiophen:Polystyrolsulfonsäure), PEDOT (Poly-3,4-ethylendioxy-thiophen), m-MTDATA (4,4',4"-Tris[phenyl(m-tolyl)amino]triphenylamin), Spiro-TAD (2,2',7,7'-Tetrakis(N,N-diphenylamino)-9,9-spirobifluoren), DNTPD (4,4'-Bis[N-[4-{N,N-bis(3-methyl-phenyl)amino}phenyl]-N-phenylamino]biphenyl), NPB (N,N'-Bis-(1-naphthalenyl)-N,N'-bis-phenyl-(1,1'-biphenyl)-4,4'-diamin), NPNPB (N,N'-Diphenyl-N,N'-di-[4-(N,N-diphenyl-amino)phenyl]benzol), MeO-TPD (N,N,N',N'-Tetrakis(4-methoxyphenyl)benzol), HAT-CN (1,4,5,8,9,11-Hexaazatriphenylen-hexacarbonitril) oder Spiro-NPD (N,N'-diphenyl-N,N'-Bis-(1-naphthyl)-9,9'-spirobifluorene-2,7-diamin) dienen. Beispielhaft ist die Schichtdicke 10-80 nm. Des Weiteren können kleine Moleküle verwendet werden (z. B. KupferPhthalocyanin (CuPc, z. B. 10 nm dick)) oder Metalloxide wie etwa $MoO_3$, $V_2O_5$.

Als Materialien einer HTL können tertiäre Amine, Carbazolderivate, mit Polystyrolsulfonsäure dotiertes Polyethylendioxythiophen, mit Camphersulfonsäure dotiertes Polyanilin poly-TPD (Poly(4-butylphenyl-diphenylamin)), [alpha]-NPD (Poly(4-butylphenyl-diphenyl-amin)), TAPC (4,4'-Cyclohexyliden-bis[*N,N*-bis(4-methylphenyl)benzenamin]), TCTA (Tris(4-carbazoyl-9-ylphenyl)amin), 2-TNATA (4,4',4"-Tris[2-naphthyl(phenyl-amino]triphenylamin), Spiro-TAD, DNTPD, NPB, NPNPB, MeO-TPD, HAT-CN oder TrisPcz (9,9'-Diphenyl-6-(9-phenyl-9H-carbazol-3-yl)-9H,9'H-3,3'-bicarbazol) dienen. Beispielhaft ist die Schichtdicke 10 nm bis 100 nm.

Die HTL kann eine p-dotierte Schicht aufweisen, die einen anorganischen oder organischen Dotierstoff in einer organischen löcherleitenden Matrix aufweist. Als anorganischer Dotierstoff können beispielsweise Übergangsmetalloxide wie etwa Vanadiumoxid, Molybdänoxid oder Wolframoxid genutzt werden. Als organische Dotierstoffe können beispielsweise Tetrafluorotetracyanoquinodimethan (F4-TCNQ), Kupfer-Pentafluorobenzoat (Cu(I)pFBz) oder Übergangsmetallkomplexe verwendet werden. Beispielhaft kann die Schichtdicke 10 nm bis 100 nm betragen.

Als Materialien einer Elektronenblockierschicht können beispielsweise mCP (1,3-Bis(carbazol-9-yl)benzol), TCTA, 2-TNATA, mCBP (3,3-Di(9H-carbazol-9-yl)biphenyl), tris-Pcz (9,9'-Diphenyl-6-(9-phenyl-9H-carbazol-3-yl)-9H,9'H-3,3'-bicarbazol), CzSi (9-(4-tert-Butylphenyl)-3,6-bis(triphenylsilyl)-9H-carbazol) oder DCB (N,N'-Dicarbazolyl-1,4-dimethylbenzol) dienen. Beispielhaft kann die Schichtdicke 10 nm bis 50 nm betragen.

Die Emissionsschicht B (Emitter-Schicht EML) enthält (oder besteht aus) Emittermaterial oder eine Mischung aufweisend mindestens zwei Emittermaterialien und optional ein oder mehreren Hostmaterialien. Die Emissionsschicht B enthält mindestens einen Emitter E, der Licht mittels thermisch aktivierter verzögerter Fluoreszenz (TADF) emittiert. Geeignete Hostmaterialien sind beispielsweise mCP, TCTA, 2-TNATA, mCBP, CBP (4,4'-Bis-(N-carbazolyl)-biphenyl), Sif87 (Dibenzo[b,d]thiophen-2-yltriphenylsilan), Sif88 (Dibenzo[b,d]thiophen-2-yl)diphenylsilan) oder DPEPO (Bis[2-((oxo)diphenylphosphino)phenyl]ether).

Für im Grünen oder im Roten emittierendes Emittermaterial oder einer Mischung aufweisend mindestens zwei Emittermaterialien eignen sich die gängigen Matrixmaterialien wie CBP. Für im Blauen emittierendes Emittermaterial oder einer Mischung aufweisend mindestens zwei Emittermaterialien können UHG-Matrixmaterialien (Ultra-High energy Gap Materialien) (siehe z. B. M.E. Thompson et al., Chem. Mater. 2004, 16, 4743) oder andere sogenannten Wide-Gap-Matrixmaterialien eingesetzt werden. Beispielhaft ist die Schichtdicke 10 nm bis 250 nm.

Die Lochblockierschicht HBL kann beispielsweise BCP (2,9-Dimethyl-4,7-diphenyl-1,10-phenanthrolin = Bathocuproin), Bis-(2-methyl-8-hydroxychinolinato)-(4-phenylphenolato)-aluminium(III) (BAlq), Nbphen (2,9-Bis(naphthalen-2-yl)-4,7-diphenyl-1,10-phenanthrolin), Alq3 (Aluminium-tris(8-hydroxychinolin)), TSPO1 (Diphenyl-4-triphenylsilylphenyl-phosphinoxid) oder TCB/TCP (1,3,5-Tris(N-carbazolyl)benzol/ 1,3,5-tris(carbazol)-9-yl) benzol) aufweisen. Beispielhaft kann die Schichtdicke 10 nm bis 50 nm betragen.

Die Elektronentransportschicht ETL kann beispielsweise Materialien auf Basis von $AlQ_3$, TSPO1, BPyTP2 (2,7-Di(2,2'-bipyridin-5-yl)triphenyl), Sif87, Sif88, BmPyPhB (1,3-Bis[3,5-di(pyridin-3-yl)phenyl]benzol) oder BTB (4,4'-Bis-[2-(4,6-diphenyl-1,3,5-triazinyl)]-1,1'-biphenyl) aufweisen. Beispielhaft kann die Schichtdicke 10 nm bis 200 nm betragen.

Als Materialien einer dünnen Elektroneninjektionsschicht EIL können beispielsweise CsF, LiF, 8-Hydroxyquinolinolatolithium (Liq), $Li_2O$, $BaF_2$, MgO oder NaF verwendet werden.

Als Materialien der Kathodenschicht können Metalle oder Legierungen dienen, beispielsweise Al, Al > AlF, Ag, Pt, Au, Mg, Ag:Mg. Typische Schichtdicken betragen 100 nm bis 200 nm. Insbesondere werden ein oder mehrere Metalle verwendet, die stabil an der Luft sind und/oder die selbstpassivierend, beispielsweise durch Ausbildung einer dünnen schützenden Oxidschicht, sind.

Als Materialien zur Verkapselung sind beispielsweise Aluminiumoxid, Vanadiumoxid, Zinkoxid, Zirkoniumoxid, Titanoxid, Hafniumoxid, Lanthanoxid, Tantaloxid und Mischungen aus zwei oder mehr daraus geeignet.

Gemäß einer Ausführungsform der Offenbarung weist die offenbarte Beleuchtungseinrichtung eine externe Quanteneffizienz (EQE) bei 1000 cd/$m^2$ von größer 5 %, insbesondere von größer 8 %, insbesondere von größer 10 %, oder von größer 13 %, oder von größer 16 % und insbesondere von größer 20 % und/oder einen LT80 Wert (Lebensdauer bis zu der die Leuchtdichte bei konstanter Stromdichte auf 80% der ursprünglichen Leuchtdichte abgesunken ist, etwa gemessen bei 70 °C) bei 500 cd/$m^2$ von größer 30 h, insbesondere von größer 70 h, oder von größer 100 h, oder von größer 150 h und insbesondere von größer 200 h auf.

Gemäß einer Ausführungsform der Offenbarung weist die offenbarte Beleuchtungseinrichtung eine externe Quanteneffizienz (EQE) bei 1000 cd/$m^2$ von größer 5 %, insbesondere von größer 8 %, insbesondere von größer 10 %, oder von größer 13 %, oder von größer 16 % und insbesondere von größer 20 % und/oder einen LT80 Wert (Lebensdauer bis zu der die Leuchtdichte bei konstanter Stromdichte auf 80% der ursprünglichen Leuchtdichte abgesunken ist, etwa gemessen bei 20 °C) bei 500 cd/$m^2$ von größer 30 h, insbesondere von größer 70 h, oder von größer 100 h, oder von größer 150 h und insbesondere von größer 200 h auf.

Auch das Kraftfahrzeug, das eine offenbarte Beleuchtungseinrichtung umfasst, unterscheidet sich von Kraftfahrzeugen des Standes Technik darin, dass die Beleuchtung bei erhöhter Temperatur verbesserte optische Eigenschaften und eine längere Lebensdauer als die bekannten OLED-Beleuchtungseinrichtungen zeigt. Daher betrifft ein weiterer Aspekt der vorliegenden Offenbarung ein Kraftfahrzeug umfassend mindestens eine offenbarte Beleuchtungseinrichtung.

Bei den im Zusammenhang mit Beleuchtungseinrichtungen definierten Eigenschaften handelt es sich um bevorzugte Ausführungsformen, die in gleicher Weise für das Kraftfahrzeug definiert werden können. Ferner erlaubt die offenbarte Beleuchtungseinrichtung die effektive Erzeugung von Licht bei erhöhten Betriebstemperaturen.

Daher betrifft ein weiterer Aspekt der vorliegenden Offenbarung ein Verfahren zum Erzeugen von Licht mittels einer organischen lichtemittierenden Diode (OLED) bei einer Betriebstemperatur dieser im Bereich von 30°C bis 160°C, umfassend die Schritte:

(i) Bereitstellen der erfindungsgemäßen OLED, die Eigenschaften wie hierin definiert aufweist; und
(ii) Anlegen einer elektrischen Spannung an die OLED aus Schritt (i).

Anders ausgedrückt betrifft die vorliegende Offenbarung auch ein Verfahren zum Erzeugen von Licht mittels einer Beleuchtungseinrichtung für ein Kraftfahrzeug gemäß der vorliegenden Offenbarung bei einer Betriebstemperatur dieser im Bereich von 30°C bis 160°C, umfassend die Schritte:

(i) Bereitstellen der Beleuchtungseinrichtung für ein Kraftfahrzeug gemäß der vorliegenden Offenbarung; und
(ii) Anlegen einer elektrischen Spannung an die Beleuchtungseinrichtung aus Schritt (i).

Es wird erkannt werden, dass die im Zusammenhang mit der Beleuchtungseinrichtung definierten Eigenschaften und bevorzugten Ausführungsformen in gleicher Weise für das offenbarte Verfahren zum Erzeugen von Licht

mittels einer solchen Beleuchtungseinrichtung definiert werden können.

Gemäß einer bevorzugten Ausführungsform wird durch das offenbarte Verfahren Licht im Wellenlängenbereich von 420 bis 600 nm erzeugt.

Gemäß einer bevorzugten Ausführungsform stellt die bei der Durchführung des Verfahrens verwendete Beleuchtungseinrichtung bzw. OLED einen Teil einer Beleuchtungseinrichtung für ein Kraftfahrzeug gemäß der vorliegenden Offenbarung dar.

Die nachfolgenden Beispiele und die Figur 1 dienen der näheren Erläuterung der Erfindung.

## Kurze Beschreibung der Figur

**Figur 1** zeigt die zwei Messpunkte bei Raumtemperatur und bei 70 °C, wobei die Lebensdauer relativ zu der Lebensdauer bei Raumtemperatur, welche dem normierten Wert 1.0 entspricht, angegeben ist, für das offenbarte System (gefülltes Rechteck: offenbarte Beispiel 1, ungefülltes Dreieck: Vergleichsbeispiel).

## Beispiel

Beispiel 1

Es wurde ein OLED-Pixel mit folgendem Aufbau hergestellt (Anteil des Emitters und des Hostmoleküls an der Emissionsschicht ist jeweils in Massenprozent angegeben):

| Schicht | Dicke | Material |
|---|---|---|
| 8 | 100 nm | Al |
| 7 | 2 nm | Liq |
| 6 | 40 nm | NBPhen |
| 5 | 20 nm | 9-[3,5-Bis(2-dibenzofuranyl)phenyl]-9H-carbazol:T2T:**E1** (70:20:10) |
| 4 | 8 nm | 9-[3,5-Bis(2-dibenzofuranyl)phenyl]-9H-carbazol |
| 3 | 10 nm | TCTA |
| 2 | 75 nm | NPB |
| 1 | 130 nm | ITO |
| Substrat | | Glas |

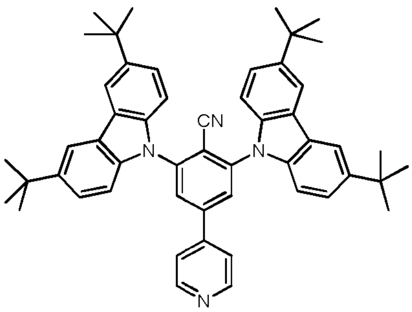

**E1**

Es wurden die LT80 Werte bei OLED-Pixel bei Raumtemperatur und für 70°C gemessen. Für die Lebensdauern bei 70°C wurden die Pixel in einen Ofen gelegt und alle 1 bis 2 Stunden herausgenommen und mit einer Minolta Leuchtdichtekamera die Leuchtdichte gemessen. Die LT80 Werte bei 500 cd/m$^2$ wurden nach folgender Gleichung bestimmt:

$$LT80\left(500\frac{cd^2}{m^2}\right) = LT80(L_0)\left(\frac{500\frac{cd^2}{m^2}}{L_0}\right)^{-1.6}$$

wobei $L_0$ der Startleuchtdichte bei der eingesetzten Stromdichte entspricht.

Wie in Figur 1 gezeigt sind ebenso die Werte einer literaturbekannten Vergleichs-OLED, die phosphoreszente Emitter in der Emissionsschicht aufweist, eingefügt, welche der Publikation Pang et al. (Thermal behavior and indirect life test of largearea OLED lighting panels, Journal of Solid State Lighting, 2014, 1:7; DOI: 10.1186/2196-1107-1-7) entnommen sind. Die Lebensdauer der offenbarten OLED verkürzt sich bei 70 °C auf 35% der Raumtemperaturlebensdauer, das Vergleichsbeispiel zeigt eine deutlich stärkere Verkürzung der Lebensdauer auf 11%.

## Patentansprüche

1. Verwendung einer Beleuchtungseinrichtung, enthaltend mindestens eine organische lichtemittierende Diode (OLED) mit einer Emissionsschicht B, wobei die Emissionsschicht B mindestens einen Emitter E enthält, der Licht mittels thermisch aktivierter verzögerter Fluoreszenz (TADF) emittiert,

   wobei der Emitter E eine Glasübergangstemperatur von über 130 °C aufweist, und wobei die Zusammensetzung der Emissionsschicht B neben dem Emitter E ein elektronendominantes und ein lochdominantes Hostmaterial aufweist, wobei das HOMO (höchstes besetztes Molekülorbital) des lochdominanten Hostmaterials energetisch unter dem HOMO des Emitters E liegt und das LUMO (niedrigstes unbesetztes Molekülorbital) des elektronendominanten Hostmaterials energetisch über dem LUMO des Emitters E liegt,
   in oder an einem Kraftfahrzeug.

2. Verwendung nach Anspruch 1, wobei der Emitter E eine Energiedifferenz ΔE zwischen dem untersten angeregten Singulett-Zustand S1 und dem darunterliegenden Triplett-Zustand T1 von nicht mehr als 0,3 eV aufweist.

3. Verwendung nach einem der Ansprüche 1 oder 2, wobei die OLED ein Emissionsmaximum im Bereich von 420 nm bis 800 nm aufweist.

4. Verwendung nach einem der Ansprüche 1 bis 3, wobei die externe Quanteneffizienz (EQE) der OLED mit steigender Temperatur steigt.

5. Verwendung nach einem der Ansprüche 1 bis 4, wobei die Beleuchtungseinrichtung eine Signalleuchte an der Außenseite des Kraftfahrzeugs ist, die ausgewählt sein kann aus der Gruppe bestehend aus einem alternierend leuchtenden Fahrtrichtungsanzeiger, einem Schlusslicht, einem Bremslicht, einer optional hochgesetzten Bremsleuchte und einem Außendisplay.

6. Verwendung nach einem der Ansprüche 1 bis 5, wobei der Emitter E eine Molekülmasse von mehr als 1000 g/mol aufweist.

7. Verwendung nach einem der Ansprüche 1 bis 6, wobei der Emitter E ein rein organischer TADF-Emitter ist.

8. Verwendung nach einem der Ansprüche 1 bis 7, wobei der Abstand zwischen dem LUMO des elektronendominanten Hostmaterials und dem LUMO des Emitters E weniger als 0,5 eV, bevorzugt weniger als 0,3 eV, stärker bevorzugt weniger als 0,2 eV beträgt.

9. Verwendung nach einem der Ansprüche 1 bis 8, wobei der Abstand zwischen dem HOMO des lochdominanten Hostmaterials und dem HOMO des Emitters E weniger als 0,5 eV, bevorzugt weniger als 0,3 eV, stärker bevorzugt weniger als 0,2 eV beträgt.

10. Verwendung nach einem der Ansprüche 1 bis 9, wobei die Emissionsschicht B besteht aus:

    (a) dem Emitter E;

(b) einem oder mehreren Hostmaterialien H, die von dem Emitter E verschieden sind;
(c) einem oder mehreren TADF-Emittern K, die von dem Emitter E verschieden sind, und
(d) einer oder mehrerer weiterer Komponenten ausgewählt aus der Liste bestehend aus einem oder mehreren Emittern F, die keine TADF-Emitter darstellen, einem oder mehreren Farbstoffen C, einem oder mehreren Lösungsmitteln L und Kombinationen aus zwei oder mehr daraus.

**11.** Verwendung nach einem der Ansprüche 1 bis 10, wobei die Beleuchtungseinrichtung am oder im Kraftfahrzeug so angeordnet wird, dass sie beim Langzeitbetrieb des Kraftfahrzeugs bei einer Außentemperatur von 20°C einer um mindestens 10°C gegenüber der Außentemperatur erhöhten Betriebstemperatur ausgesetzt wird.

**12.** Kraftfahrzeug umfassend mindestens eine Beleuchtungseinrichtung, wie in einem der Ansprüche 1 bis 11 definiert.

**13.** Verfahren zum Erzeugen von Licht mittels einer organischen lichtemittierenden Diode (OLED) bei einer Betriebstemperatur dieser im Bereich von 30°C bis 160°C, umfassend die Schritte:

(i) Bereitstellen der OLED, die Eigenschaften wie in einem der Ansprüche 1 bis 11 definiert aufweist; und
(ii) Anlegen einer elektrischen Spannung an die OLED aus Schritt (i),

wobei die OLED einen Teil einer Beleuchtungseinrichtung, wie in einem der Ansprüche 1 bis 11 definiert, in oder an einem Kraftfahrzeug darstellt.

**14.** Verfahren nach Anspruch 13, wobei Licht im Wellenlängenbereich von 420 bis 800 nm erzeugt wird.

## Claims

**1.** The use of a lighting device comprising at least one organic light-emitting diode (OLED) with an emission layer B, wherein the emission layer B comprises at least one emitter E that emits light by means of thermally activated delayed fluorescence (TADF),

wherein the emitter E has a glass transition temperature of over 130 °C, and wherein the composition of the emission layer B comprises, in addition to the emitter E, an electron-dominant and a hole-dominant host material, wherein the HOMO (highest occupied molecular orbital) of the hole-dominant host material lies energetically below the HOMO of the emitter E, and the LUMO (lowest unoccupied molecular orbital) of the electron-dominant host material lies energetically above the LUMO of the emitter E,
in or on a motor vehicle.

**2.** The use according to claim 1, wherein the emitter E has an energy difference $\Delta E$ between the lowest excited singlet state S1 and the underlying triplet state T1 of no more than 0.3 eV.

**3.** The use according to any one of claims 1 or 2, wherein the OLED has an emission maximum in the range from 420 nm to 800 nm.

**4.** The use according to any one of claims 1 to 3, wherein the external quantum efficiency (EQE) of the OLED increases with rising temperature.

**5.** The use according to any one of claims 1 to 4, wherein the lighting device is a signal light on the exterior of the motor vehicle, which may be selected from the group consisting of an alternating directional indicator, a tail light, a brake light, an optional raised brake light, and an exterior display.

**6.** The use according to any one of claims 1 to 5, wherein the emitter E has a molecular weight of more than 1000 g/mol.

**7.** The use according to any one of claims 1 to 6, wherein the emitter E is a purely organic TADF emitter.

**8.** The use according to any one of claims 1 to 7, wherein the distance between the LUMO of the electron-dominant host material and the LUMO of the emitter E is less than 0.5 eV, preferably less than 0.3 eV, more preferably less than 0.2 eV.

9. The use according to any one of claims 1 to 8, wherein the distance between the HOMO of the hole-dominant host material and the HOMO of the emitter E is less than 0.5 eV, preferably less than 0.3 eV, more preferably less than 0.2 eV.

10. The use according to any one of claims 1 to 9, wherein the emission layer B consists of:

(a) the emitter E;
(b) one or more host materials H that are different from the emitter E;
(c) one or more TADF emitters K, which are different from the emitter E, and
(d) one or more further components selected from the list consisting of one or more emitters F that are not TADF emitters, one or more dyes C, one or more solvents L, and combinations of two or more thereof.

11. The use according to any one of claims 1 to 10, wherein the lighting device is arranged on or in the motor vehicle such that, during long-term operation of the motor vehicle at an outside temperature of 20°C, it is subjected to an operating temperature that is at least 10°C higher than the outside temperature.

12. A motor vehicle comprising at least one lighting device as defined in any one of claims 1 to 11.

13. A method for generating light using an organic light-emitting diode (OLED) at an operating temperature of the OLED in the range of 30°C to 160°C, comprising the steps:

(i) providing the OLED having characteristics as defined in any one of claims 1 to 11; and
(ii) applying an electrical voltage to the OLED from step (i),

wherein the OLED forms part of a lighting device, as defined in any one of claims 1 to 11, in or on a motor vehicle.

14. The method according to claim 13, wherein light is generated in the wavelength range of 420 to 800 nm.

## Revendications

1. Utilisation d'un dispositif d'éclairage, comprenant au moins une diode électroluminescente organique (OLED) avec une couche d'émission B, la couche d'émission B contenant au moins un émetteur E qui émet de la lumière au moyen d'une fluorescence retardée thermiquement activée (TADF),

l'émetteur E présentant une température de transition vitreuse supérieure à 130 °C, et la composition de la couche d'émission B comprenant, outre l'émetteur E, un matériau hôte à dominante électronique et un matériau hôte à dominance de trous, le HOMO (orbitale moléculaire la plus haute occupée) du matériau hôte à dominance de trous étant situé énergétiquement en dessous du HOMO de l'émetteur E et le LUMO (orbitale moléculaire la plus basse vacante) du matériau hôte à dominante électronique étant situé énergétiquement au-dessus du LUMO de l'émetteur E,
dans ou sur un véhicule automobile.

2. Utilisation selon la revendication 1, dans laquelle l'émetteur E présente une différence d'énergie $\Delta E$ entre l'état singulet excité le plus bas S1 et l'état triplet sous-jacent T1 ne dépassant pas 0,3 eV.

3. Utilisation selon l'une des revendications 1 ou 2, dans laquelle la OLED présente un maximum d'émission dans la plage de 420 nm à 800 nm.

4. Utilisation selon l'une des revendications 1 à 3, dans laquelle l'efficacité quantique externe (EQE) de la OLED augmente avec l'augmentation de la température.

5. Utilisation selon l'une des revendications 1 à 4, dans laquelle le dispositif d'éclairage est un feu de signalisation disposé à l'extérieur du véhicule automobile, pouvant être sélectionné dans le groupe constitué d'un indicateur de direction clignotant, d'un feu arrière, d'un feu stop, d'un feu stop optionnellement surélevé et d'un affichage extérieur.

6. Utilisation selon l'une des revendications 1 à 5, dans laquelle l'émetteur E présente une masse moléculaire supérieure à 1000 g/mol.

**7.** Utilisation selon l'une des revendications 1 à 6, dans laquelle l'émetteur E est un émetteur TADF purement organique.

**8.** Utilisation selon l'une quelconque des revendications 1 à 7, dans laquelle la distance entre le LUMO du matériau hôte à dominante électronique et le LUMO de l'émetteur E est inférieure à 0,5 eV, de préférence inférieure à 0,3 eV, de manière plus préférée inférieure à 0,2 eV.

**9.** Utilisation selon l'une des revendications 1 à 8, dans laquelle la distance entre le HOMO du matériau hôte à dominance de trous et le HOMO de l'émetteur E est inférieure à 0,5 eV, de préférence inférieure à 0,3 eV, de manière plus préférée inférieure à 0,2 eV.

**10.** Utilisation selon l'une des revendications 1 à 9, dans laquelle la couche d'émission B est constituée de :

(a) l'émetteur E ;
(b) un ou plusieurs matériaux hôtes H différents de l'émetteur E ;
(c) un ou plusieurs émetteurs TADF K différents de l'émetteur E, et
(d) un ou plusieurs autres composants sélectionnés dans la liste constituée par un ou plusieurs émetteurs F qui ne sont pas des émetteurs TADF, un ou plusieurs colorants C, un ou plusieurs solvants L et des combinaisons de deux ou plus de ceux-ci.

**11.** Utilisation selon l'une des revendications 1 à 10, dans laquelle le dispositif d'éclairage est disposé sur ou dans le véhicule automobile de sorte qu'il soit, en fonctionnement prolongé du véhicule automobile à une température extérieure de 20 °C, exposé à une température de fonctionnement supérieure d'au moins 10 °C par rapport à la température extérieure.

**12.** Véhicule automobile comprenant au moins un dispositif d'éclairage tel que défini dans l'une des revendications 1 à 11.

**13.** Procédé pour générer de la lumière au moyen d'une diode électroluminescente organique (OLED) à une température de fonctionnement de celle-ci dans la plage de 30 °C à 160 °C, comprenant les étapes suivantes :

(i) la fourniture de la OLED présentant des propriétés telles que définies dans l'une des revendications 1 à 11 ; et
(ii) l'application d'une tension électrique à l'OLED de l'étape (i),

la diode électroluminescente organique (OLED) faisant partie d'un dispositif d'éclairage tel que défini dans l'une quelconque des revendications 1 à 11, dans ou sur un véhicule automobile.

**14.** Procédé selon la revendication 13, dans lequel la lumière est générée dans la plage de longueurs d'onde de 420 à 800 nm.

Fig. 1

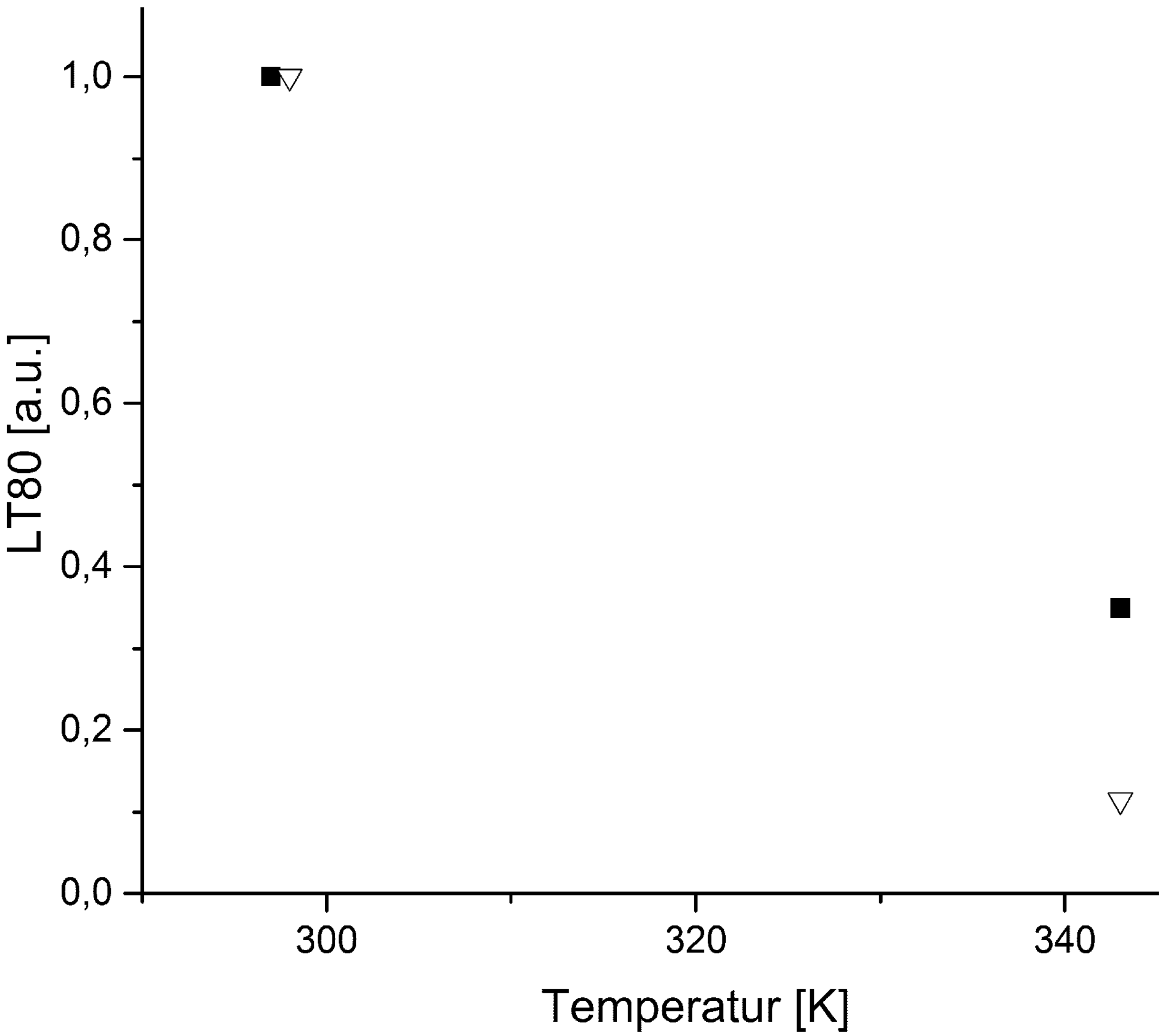

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- DE 10217633 A
- JP 2017188399 A
- DE 102009009087 A
- DE 102013217848 A
- DE 102014111119 A
- WO 2014179824 A
- EP 3113239 A


### In der Beschreibung aufgeführte Nicht-Patentliteratur


- **ZYSMAN-COLMAN**. Purely Organic Thermally Activated Delayed Fluorescence Materials for Organic Light-Emitting Diodes.. *Adv Mater.*, June 2017, vol. 29, 22
- **B. M.E. THOMPSON et al.** *Chem. Mater.*, 2004, vol. 16, 4743
- **PANG et al.** Thermal behavior and indirect life test of largearea OLED lighting panels. *Journal of Solid State Lighting*, 2014, vol. 1, 7